(19) Europäisches Patentamt
European Patent Office
Office européen des brevets

(11) **EP 2 820 438 B1**

(12) **EUROPÄISCHE PATENTSCHRIFT**

(45) Veröffentlichungstag und Bekanntmachung des Hinweises auf die Patenterteilung:
**25.05.2016  Patentblatt 2016/21**

(21) Anmeldenummer: **13707276.5**

(22) Anmeldetag: **26.02.2013**

(51) Int Cl.:
***G01R 33/00*** *(2006.01)*    ***G01R 33/07*** *(2006.01)*
***G01R 15/20*** *(2006.01)*

(86) Internationale Anmeldenummer:
**PCT/EP2013/000564**

(87) Internationale Veröffentlichungsnummer:
**WO 2013/127522 (06.09.2013 Gazette 2013/36)**

(54) **VERFAHREN UND VORRICHTUNG ZUR MESSUNG VON STRÖMEN ODER MAGNETFELDERN MIT HALL-SENSOREN**

METHOD AND DEVICE FOR MEASURING CURRENTS OR MAGNETIC FIELDS USING HALL SENSORS

PROCÉDÉ ET DISPOSITIF DE MESURE DE COURANTS OU DE CHAMPS MAGNÉTIQUES AU MOYEN DE CAPTEURS À EFFET HALL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2012  DE 102012003978**

(43) Veröffentlichungstag der Anmeldung:
**07.01.2015  Patentblatt 2015/02**

(73) Patentinhaber: **Fraunhofer Gesellschaft zur Förderung der angewandten Forschung e.V.**
**80686 München (DE)**

(72) Erfinder:
• **HACKNER, Michael**
**93155 Hernau, OT Haag (DE)**
• **HOHE, Hans-Peter**
**91332 Heiligenstadt (DE)**
• **SAND, Markus**
**92723 Tännesberg (DE)**

(74) Vertreter: **Gagel, Roland**
**Patentanwalt Dr. Roland Gagel**
**Landsberger Strasse 480a**
**81241 München (DE)**

(56) Entgegenhaltungen:
**DE-A1-102009 017 881    US-A1- 2009 009 164**

• **ALEXANDRE KERLAIN ET AL: "Hybrid Hall microsystem for high dynamic range/large bandwidth magnetometry applications", 2008 IEEE SENSORS,LECCE, ITALY, IEEE, PISCATAWAY, NJ, USA, 26. Oktober 2008 (2008-10-26), Seiten 1044-1047, XP031375260, ISBN: 978-1-4244-2580-8 in der Anmeldung erwähnt**

EP 2 820 438 B1

## Beschreibung

## Technisches Anwendungsgebiet

Die vorliegende Erfindung betrifft ein Verfahren sowie eine Vorrichtung zur Messung von Strömen oder Magnetfeldern mit mindestens einem Hall-Sensor, der in Spinning-Current-Technik betrieben wird, wobei Sensorsignale des Hall-Sensors mit einem Analog-Digital-Wandler in digitale Signale gewandelt werden, die digitalen Signale des Analog-Digital-Wandlers ausgelesen und für jede Spinning-Current-Phase über einen ersten Zeitraum kombiniert werden, um einen ersten Abtastwert zu erhalten, und die ersten Abtastwerte der Spinning-Current-Phasen eines Spinning-Current-Zyklus zur Bildung eines Spinning-Current-Messwertes des Stroms oder Magnetfeldes aufaddiert werden.

## Stand der Technik

US 2009/009164 A1 (UTSUNO KIKUO, 08.01.2009) offenbart ein Verfahren zur Messung von Strömen oder Magnetfeldern mit einem Hall-Sensor, der in Spinning-Current-Technik betrieben wird, wobei Sensorsignale des Hall-Sensors mit einem Analog-Digital-Wandler in digitale Signale gewandelt werden.

Strommessung in elektrischen Antrieben ist seit langem eine Domäne von Shunt-Widerständen. Diese sind in der Regel einfach zu verwenden, klein in der Bauform und erlauben eine schnelle Signalauswertung. Allerdings können Shunt-Widerstände nicht eingesetzt werden, wenn z.B. eine galvanisch getrennte Messung erfolgen soll, der stromführende Leiter nicht aufgetrennt werden darf oder kann, oder wenn im System so große Ströme auftreten können, dass ein Shunt zerstört oder beschädigt würde. In diesen Fällen bieten sich magnetische Messverfahren auf Basis von Hall-Sensoren zur Strommessung an. Gängige Hall-Sensor-Systeme sind Strom-Wandler-Module mit magnetisierbarem Kern für die magnetische Flussverstärkung. In einem rückgekoppelten System wird damit eine recht hohe Messgenauigkeit und Mess-Bandbreite erreicht. Allerdings sind bei dieser Lösung Volumen und Kosten relativ hoch, da je nach Dimensionierung viel magnetisch aktives Material benötigt wird.

Zur Verringerung von Volumen und Kosten wäre es wünschenswert, die Magnetfeldsensoren ohne magnetischen Kern zu verwenden. Das Hauptproblem bei der Strommessung mit Hall-Sensoren ohne magnetischen Kern ist jedoch der relativ hohe Sensor-Offset in Bezug auf den Signal-Hub. Zur Unterdrückung des Offsets ist in fast jedem Hall-Sensor-System das so genannte Spinning-Current-Prinzip implementiert. Dabei werden für jede Messung die Betriebs-Strom-Richtung im Hall-Element bzw. Hall-Sensor und gleichzeitig auch die Anschlüsse für die Signal-Auskopplung (Hall-Kontakte) ein- oder mehrfach umgeschaltet. Aus den Einzelmessungen in den verschiedenen Spinning-Current-Phasen (meist zwei oder vier) wird ein Summenwert gebildet, dessen Offset-Anteil deutlich geringer ist als in den Einzelphasen. Allerdings ist durch die Nutzung des Spinning-Current-Prinzips die mögliche Messfrequenz durch die Einschwingvorgänge beim Umschalten zwischen den einzelnen Phasen und durch die notwendige Genauigkeit der Messwerte begrenzt.

In modernen elektrischen Antrieben werden zur Steuerung der Elektromotoren hoch präzise und dynamische Umrichter verwendet, die getaktet betrieben werden. Zur präzisen Regelung der Umrichterspannungen und -ströme werden Messwerte dieser Größen mit hoher Genauigkeit und niedrigem Rauschen benötigt. Dazu sind Hall-Sensor-Systeme zur Strommessung mit $\Delta\Sigma$-Modulatoren ($\Delta\Sigma M$) zur Analog-Digital-Umsetzung ideal geeignet, wenn diese synchron zum Umrichter betrieben werden. In diesem Fall kann über volle Perioden der Umrichter-Taktung integriert werden, wodurch ein sehr präziser Messwert entsteht. Die Taktfrequenz liegt meistens im Bereich von einigen kHz bis ca. 20 kHz, was durchaus noch in einem möglichen Bereich für das Spinning-Current-Verfahren liegt. A. Kerlain et al., "Hybrid Hall microsystem for high dynamic range/large bandwidth magnetometry applications", IEEE SENSORS 2008 Conference, Seiten 1044 bis 1047, zeigen ein Beispiel für ein derartiges Hall-Sensor-System.

Allerdings wird in der Praxis immer auch eine Erkennung von Kurzschlussströmen in sehr kurzer Zeit gefordert, damit die Halbleiterschalter durch den Kurzschluss nicht thermisch überlastet und dadurch beschädigt oder zerstört werden. Dazu sind Messzyklen von maximal 10 µs Dauer gefordert. Diese kurzen Messzeiten sind für derzeit bekannte nach dem Spinning-Current-Prinzip arbeitende Hall-Sensor-Systeme nicht sinnvoll, wenn gleichzeitig für die Regelung präzise Messwerte zur Verfügung gestellt werden sollen. Der Anteil der Einschwingzeit nach dem Umschalten der Spinning-Current-Phasen im Verhältnis zur tatsächlichen Signalerfassungszeit wird dann so groß, dass die Signalqualität durch Rauschen deutlich gemindert wird. Für eine gleichzeitige schnelle Messung ist daher derzeit ein paralleles Zweit-System erforderlich, das jedoch den Aufwand und die Kosten der Strommessung deutlich erhöht.

Die Aufgabe der vorliegenden Erfindung besteht darin, ein Verfahren sowie eine Vorrichtung zur Messung von Strömen oder Magnetfeldern mit mindestens einem Hall-Sensor anzugeben, die eine genaue und eine schnelle Messung des Stroms oder Magnetfeldes mit geringem Aufwand ermöglichen.

## Darstellung der Erfindung

Die Aufgabe wird mit dem Verfahren und der Vorrichtung gemäß den Ansprüchen 1 und 7 gelöst. Vorteilhafte Ausgestaltungen des Verfahrens sowie der Vorrichtung sind Gegenstand der abhängigen Patentansprüche oder lassen sich der nachfolgenden Beschreibung sowie den Ausführungsbeispielen entnehmen.

Bei dem vorgeschlagenen Verfahren wird der Hall-Sensor in der Spinning-Current-Technik, beispielsweise mit zwei oder mit vier Phasen betrieben. Grundsätzlich ist ein Betrieb des Hall-Sensors mit N-Phasen möglich, wobei N $\geq$ 2. Bei dem Verfahren werden Sensorsignale des Hall-Sensors mit einem Analog-Digital-Wandler in digitale Signale gewandelt, die digitalen Signale des Analog-Digital-Wandlers ausgelesen und für jede Spinning-Current-Phase über einen ersten Zeitraum kombiniert, um einen ersten Abtastwert zu erhalten. Die ersten Abtastwerte der Spinning-Current-Phasen eines Spinning-Current-Zyklus werden zur Bildung eines Spinning-Current-Messwertes des Stroms oder Magnetfeldes aufaddiert. Die Sensorsignale bzw. Ausgangssignale des Hall-Sensors können dabei mit oder ohne vorherige Verstärkung dem Analog-Digital-Wandler zugeführt werden. Das Verfahren zeichnet sich dadurch aus, dass die digitalen Signale des Analog-Digital-Wandlers für jede Spinning-Current-Phase mehrmals über jeweils einen zweiten Zeitraum kombiniert werden, der kleiner als der erste Zeitraum ist, um mehrere zweite Abtastwerte in zeitlicher Abfolge zu erhalten, und aus dem Spinning-Current-Messwert für jede Spinning-Current-Phase ein Offset der ersten Abtastwerte berechnet und die zweiten Abtastwerte auf Basis dieses Offset korrigiert werden, um Offset-korrigierte schnelle Messwerte des Stroms oder Magnetfeldes zu erhalten.

Bei dem vorgeschlagenen Verfahren werden somit die genaue und die schnelle Strom- oder Magnetfeldmessung in einen Spinning-Current-Ablauf integriert. Damit kann zum einen der Temperaturgang des Offset der Hall-Elemente über der Temperatur ohne aufwändige Kalibrierung systematisch eliminiert werden und zum anderen kann eine Überstromsituation schnell genug mit hinreichender Genauigkeit detektiert werden. Der Schaltungsaufwand steigt gegenüber einer herkömmlichen Messung unter Nutzung des Spinning-Current-Prinzips dabei nicht wesentlich an. Insbesondere ist keine Änderung im analogen Signalpfad notwendig, der für die Messgenauigkeit ausschlaggebend ist.

Im Gegensatz zu dem bisherigen Verfahren der Messung von Magnetfeldern oder Strömen mit Hall-Sensoren unter Nutzung der Spinning-Current-Technik werden beim hier vorgeschlagenen Verfahren die Einzelphasen-Messwerte (erste Abtastwerte) nicht nach der Addition zur Bildung des Spinning-Current-Messwertes verworfen, sondern gespeichert, um aus dem Spinning-Current-Messwert den Offset dieser ersten Abtastwerte zu berechnen. Die zweiten Abtastwerte werden dann auf Basis dieses Offset korrigiert, um Offset-korrigierte zweite Abtastwerte zu erhalten, die den schnellen Messwerten des Stroms oder Magnetfeldes entsprechen. Hierbei ist in der Regel noch eine geeignete Skalierung des Offset notwendig, da die ersten und zweiten Abtastwerte über unterschiedlich lange Zeiträume kombiniert werden. Der Skalierungsfaktor entspricht dabei dem Verhältnis des zweiten Zeitraums zum ersten Zeitraum. Dieser skalierte Offset kann dann direkt von den zweiten Abtastwerten - jeweils für die entsprechende Spinning-Current-Phase - subtrahiert werden.

Mit dem vorgeschlagenen Verfahren und der nachfolgend ebenfalls beschriebenen Vorrichtung bleibt die Genauigkeit der Spinning-Current-Messwerte gegenüber bisherigen Verfahren, die rein nach dem Spinning-Current-Prinzip arbeiten, unverändert und wird nicht beeinflusst. Gleichzeitig stellen das Verfahren und die Vorrichtung jedoch auch schnelle Messwerte des Stroms oder Magnetfeldes zur Verfügung, die einer Offset-Korrektur unterzogen wurden. Die Offset-Korrektur der schnellen Messwerte wird dabei systematisch über der Temperatur oder andere Betriebs-Bedingungen nachgeführt. Die sehr genauen und die sehr schnellen Messwerte werden gleichzeitig mit demselben Sensor und analogen Vorbauten gewonnen. Es sind keine zusätzlichen analogen Komponenten erforderlich. Auch aufwändige Kalibrierungen des Sensors entfallen.

In einer bevorzugten Ausgestaltung des Verfahrens wird in bekannter Weise nach jedem Umschalten der Spinning-Current-Phase eine Wartezeit (erste Wartezeit) zwischen dem Umschalten der Spinning-Current-Phase und dem Beginn des Zeitraums für die Bildung der ersten Abtastwerte eingelegt, um Einflüsse der durch das beim Umschalten hervorgerufenen Einschwingvorgänge auf die Genauigkeit des Spinning-Current-Messwertes zu vermeiden. In gleicher Weise wird auch eine Wartezeit zwischen dem Umschalten der Spinning-Current-Phase und dem erstmaligen Beginn des zweiten Zeitraums der jeweiligen Phase für die Bildung der zweiten Abtastwerte eingelegt. Diese zweite Wartezeit kann gleich der ersten Wartezeit gewählt werden. Sie ist jedoch vorzugsweise kleiner als die erste Wartezeit, damit die zweiten Abtastwerte nach dem Umschalten der Spinning-Current-Phase schneller zur Verfügung stehen, die ja nicht die hohe Genauigkeit der ersten Abtastwerte aufweisen müssen. Die zweite Wartezeit entspricht vorzugsweise auch der Zeit zwischen jeweils zwei aufeinander folgenden zweiten Zeiträumen, wobei die (zweiten) Wartezeiten und zweiten Zeiträume jeder Spinning-Current-Phase vorzugsweise so gewählt werden, dass deren Summe genau der Länge der Spinning-Current-Phase entspricht. Damit ist die Taktung für die Bildung der zweiten Abtastwerte synchron zur Taktung des Spinning-Current-Betriebs des Hall-Sensors.

Vorzugsweise werden die Sensorsignale des Hall-Sensors mit einem $\Delta\Sigma$-Wandler erster Ordnung in digitale Signale gewandelt, dessen analoger Integrator vor jeder neuen Messung einer Spinning-Current-Phase gelöscht wird. Die Kombination der digitalen Signale über den ersten Zeitraum erfolgt vorzugsweise durch einen ersten Dezimator, die Kombination der digitalen Signale über den zweiten Zeitraum durch einen zweiten Dezimator. Die Kombination umfasst bei der vorliegenden Erfindung in der Regel eine Addition, gegebenenfalls mit weiteren Rechenoperationen, bspw. zur Bildung eines Mittelwerts.

Die zur Durchführung des Verfahrens ausgebildete Vorrichtung umfasst dementsprechend neben dem in Spinnig-Current-Technik betriebenen Hall-Sensor einen Analog-Digital-Wandler, einen ersten Kombinierer, der die digitalen Signale des Analog-Digital-Wandlers ausliest und für jede Spinning-Current-Phase über einen ersten Zeitraum kombiniert, um einen ersten Abtastwert zu erhalten, und einen Addierer, der die ersten Abtastwerte der Spinning-Current-Phasen eines Spinning-Current-Zyklus zur Bildung eines Spinning-Current-Messwertes des Stroms oder Magnetfelds aufaddiert. Ein zweiter Kombinierer kombiniert die digitalen Signale des Analog-Digital-Wandlers für jede Spinning-Current-Phase mehrmals über jeweils einen zweiten Zeitraum, der kleiner als der erste Zeitraum ist, um in zeitlicher Abfolge mehrere zweite Abtastwerte zu erhalten. Eine Korrektureinheit berechnet aus dem Spinning-Current-Messwert jeweils für jede Spinning-Current-Phase einen Offset der ersten Abtastwerte und korrigiert die zweiten Abtastwerte dann auf Basis dieses Offset, um Offset-korrigierte schnelle Messwerte des Stroms oder Magnetfeldes zu erhalten.

Das vorgeschlagene Verfahren und die zugehörige Vorrichtung lassen sich besonders vorteilhaft zur schnellen Strommessung einsetzen, beispielsweise in elektrischen Antrieben, wie sie in der Beschreibungseinleitung kurz angeführt wurden. Das Verfahren und die Vorrichtung können jedoch selbstverständlich auch allgemein zur schnellen Magnetfeld-Messung eingesetzt werden, beispielsweise in der berührungslosen Positionsmessung mit Hall-Sensoren.

## Kurze Beschreibung der Zeichnungen

Das vorgeschlagene Verfahren sowie die zugehörige Vorrichtung werden nachfolgend anhand von Ausführungsbeispielen in Verbindung mit den Zeichnungen nochmals näher erläutert. Hierbei zeigen:

Fig. 1    ein Beispiel für die Auswertung einer herkömmlichen Magnetfeldmessung unter Einsatz eines Hall-Sensors, der in Spinning-Current-Technik betrieben wird;
Fig. 2    ein Beispiel für eine Auswertung gemäß dem vorgeschlagenen Verfahren;
Fig. 3    ein zweites Beispiel für eine Auswertung gemäß dem vorgeschlagenen Verfahren; und
Fig. 4    ein Beispiel für die Synchronisierung von schneller und genauer Messung gemäß dem vorgeschlagenen Verfahren.

## Wege zur Ausführung der Erfindung

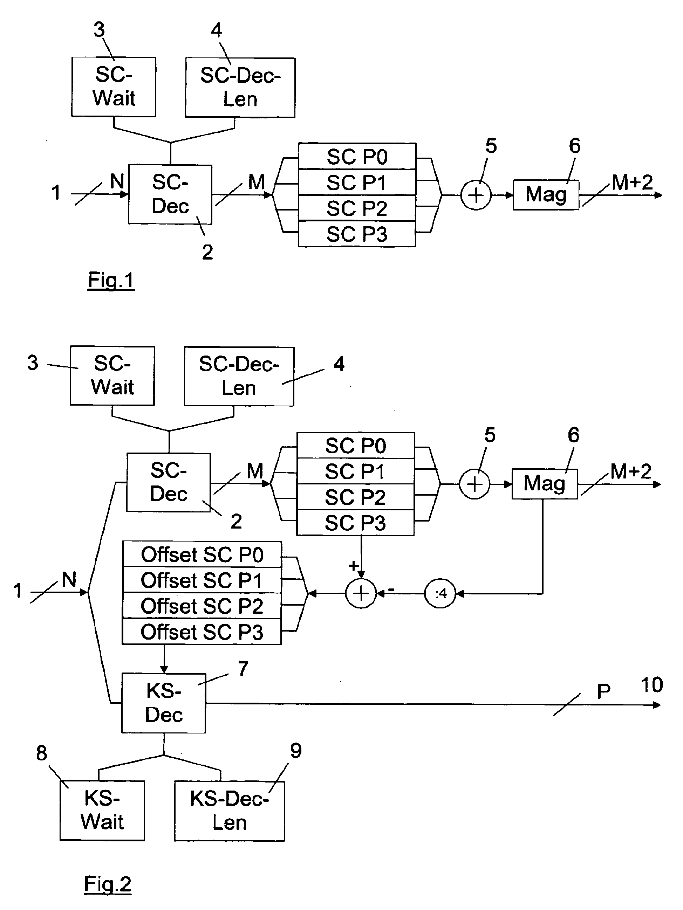

Fig. 1 zeigt ein Beispiel für eine Auswertung einer Magnetfeldmessung mit einem Hall-Sensor, der in bekannter Weise in Spinning-Current-Technik mit vier Phasen betrieben wird. Die Verschaltung des Hall-Sensors zur Umschaltung der einzelnen Phasen sowie eventuelle weitere analoge Bauelemente wie ein üblicherweise eingesetzter Vorverstärker zur Verstärkung der Ausgangssignale des Hall-Sensors sowie der erforderliche Analog-Digital-Wandler, im vorliegenden Beispiel ein $\Delta\Sigma$-Modulator, sind in dieser und den folgenden Figuren nicht dargestellt. Diese Bauteile sind jedoch aus dem Stand der Technik der Strom- oder Magnetfeld-Messung mit Hall-Sensoren hinreichend bekannt, beispielsweise aus der in der Einleitung genannten Veröffentlichung von A. Kerlain et al.

Das Ausgangssignal des Hall-Elementes wird dabei mit oder ohne Vorverstärker einem $\Delta\Sigma$-Modulator erster Ordnung zugeführt, der das Signal digitalisiert. Der analoge Integrator des $\Delta\Sigma$-Modulators wird vor jeder neuen Messung einer Spinning-Current-Phase gelöscht. Die digitale Signalfolge 1 des $\Delta\Sigma$-Modulators wird einem Dezimationsfilter 2 (einfacher digitaler Akkumulator) zugeführt. Das Dezimationsfilter 2 (SC-Dec) wird bei dem Verfahren des Standes der Technik zu Beginn jedes Spinning-Current(SC)-Zyklus gelöscht, nachdem das vorhergehende Messergebnis vom System übernommen wurde.

Nach dem Umschalten der SC-Phase wird eine kurze Zeit 3 gewartet, die der Vorverstärker benötigt, um einzuschwingen (SC-Wait: Anzahl der Takte, die nicht aufsummiert wird). Dann wird der $\Delta\Sigma$-Modulator wieder freigegeben und über einen Zeitraum 4 eine definierte Anzahl von Systemtakten (SC-Dec-Len: Dezimationslänge, auch als Tap bezeichnet) dessen Ausgangssignalfolge im Dezimator 2 zum Einzelphasen-Messwert aufsummiert.

Jeweils vier Einzelphasen-Messwerte SCP0-SCP3 werden anschließend in einem Addierer 5 aufsummiert, um den SC-Summenwert zu bilden, in der vorliegenden Patentanmeldung auch als Spinning-Current-Messwert bezeichnet, der das eigentliche Magnetfeldproportionale Messergebnis darstellt. In genau messenden Systemen werden die Einzelphasen-Messwerte SCP0-SCP3 dann nicht mehr benötigt und nach der Verrechnung im Endwert verworfen. Der berechnete Spinning-Current-Messwert 6 (Mag: Magnetfeld) wird als Endergebnis ausgegeben.

Im Gegensatz dazu werden beim vorliegenden Verfahren die Einzelphasen-Messwerte SCP0-SCP3 (im Falle eines Vier-Phasen-Spinning-Current-Betriebes) jedoch gespeichert. Fig. 2 zeigt eine schematische Darstellung der Vorgehensweise in einer Ausgestaltung des vorgeschlagenen Verfahrens. Der obere Teil der Figur entspricht der Berechnung des SC-Messwertes 6 entsprechend der Figur 1. Zusätzlich wird beim hier vorgeschlagenen Verfahren aus dem SC-Messwert 6 und den Einzelphasen-Messwerten SCP0-SCP3, in der vorliegenden Patentanmeldung auch als erste Abtastwerte bezeichnet, jeweils ein Offset für diese ersten Abtastwerte berechnet, wie dies in der Figur schematisch angedeutet ist. Dies erfolgt in folgender Weise:

Aus den gespeicherten Einzelphasen-Messwerten

$$SC_{P0} = Magnetfeld + Offset_{SCPhase0}$$

$$SC_{P1} = Magnetfeld + Offset_{SCPhase1}$$

$$SC_{P2} = Magnetfeld + Offset_{SCPhase2}$$

$$SC_{P3} = Magnetfeld + Offset_{SCPhase3}$$

wird der 4-Phasen Messwert bzw. Spinning-Current-Messwert (Magnetfeld) berechnet:

$$SC_{P0} + SC_{P1} + SC_{P2} + SC_{P3} = 4 \cdot Magnetfeld + Offset_{SCPhase0} + Offset_{SCPhase1} + Offset_{SCPhase2} + Offset_{SCPhase3}$$

Aufgrund der Eigenschaften der Hall-Sensoren gilt:

$$Offset_{SCPhase0} + Offset_{SCPhase1} + Offset_{SCPhase2} + Offset_{SCPhase3} = 0$$

und damit:

$$SC_{P0} + SC_{P1} + SC_{P2} + SC_{P3} = 4 \cdot Magnetfeld$$

Durch entsprechendes Umformen des ersten Gleichungs-Satzes

$$SC_{P0} = Magnetfeld + Offset_{SCPhase0} \Rightarrow Offset_{SCPhase0} = Magnetfeld - SC_{P0}$$

$$SC_{P1} = Magnetfeld + Offset_{SCPhase1} \Rightarrow Offset_{SCPhase0} = Magnetfeld - SC_{P1}$$

$$SC_{P2} = Magnetfeld + Offset_{SCPhase2} \Rightarrow Offset_{SCPhase2} = Magnetfeld - SC_{P2}$$

$$SC_{P3} = Magnetfeld + Offset_{SCPhase3} \Rightarrow Offset_{SCPhase3} = Magnetfeld - SC_{P3}$$

erhält man die Vorschriften, mit denen dann die jeweiligen Einzelphasen-Offsets ($Offset_{SCPhasex}$) aus den Einzelphasen-Messwerten ermittelt werden können.

Diese Einzelphasen-Offsets können dann je nach gerade aktuell eingestellter Spinning-Current-Phase vom Abtastwert der schnellen Messung abgezogen werden. Dies kann durch explizite Subtraktion nach der Messung oder durch eine entsprechende Vorbesetzung des Dezimationsfilters vor Beginn der Dezimation erfolgen.

Die schnellen Messwerte werden hierbei aus der digitalen Signalfolge 1 des $\Delta\Sigma$-Modulators gewonnen, die einem zweiten Dezimator 7 (KS-Dec) zugeführt werden. In diesem zweiten Dezimator 7 erfolgt die Berechnung der zweiten Abtastwerte in gleicher Weise wie die Berechnung der ersten Abtastwerte im ersten Dezimator 2. Die Wartezeit 8 (KS-Wait: Anzahl der Takte, die nicht aufsummiert wird) nach dem Umschalten der SC-Phase wird hierbei vorzugsweise kürzer gewählt als die erste Wartezeit 3 (SC-Wait) für die Bildung der ersten Abtastwerte. Der zweite Zeitraum 9 (KS-Dec-Len: Dezimationslänge), über den die digitalen Signale des $\Delta\Sigma$-Modulators dann zur Bildung der zweiten Abtastwerte aufsummiert werden, wird kürzer gewählt als der erste Zeitraum 4 (SC-Dec-Len) für die Bildung der ersten Abtastwerte. Die zweiten Abtastwerte werden entsprechend den aus dem SC-Messwert 6 berechneten Offsetwerten korrigiert, so dass als Ergebnis schnelle Messwerte 10 des Stroms oder Magnetfeldes ausgegeben werden können.

Eine zusätzliche Korrektur der Werte ist in der Regel erforderlich, da sich die Dezimationslängen (erste und zweite Zeiträume) für die genaue und die schnelle Messung naturgemäß unterscheiden. Dies wirkt sich in der Skalierung der Messwerte aus. Das Verhältnis dieser Skalen muss ebenfalls korrigiert werden. In günstigen Fällen kann dies durch einfache Schiebe-Operationen im Digitalteil der Mess-Vorrichtung geschehen. Im Allgemeinen muss aber mit einer gebrochenen Zahl multipliziert werden:

$$\text{Offset-Skalierungsfaktor} = \frac{KSDecLen}{SCDecLen}$$

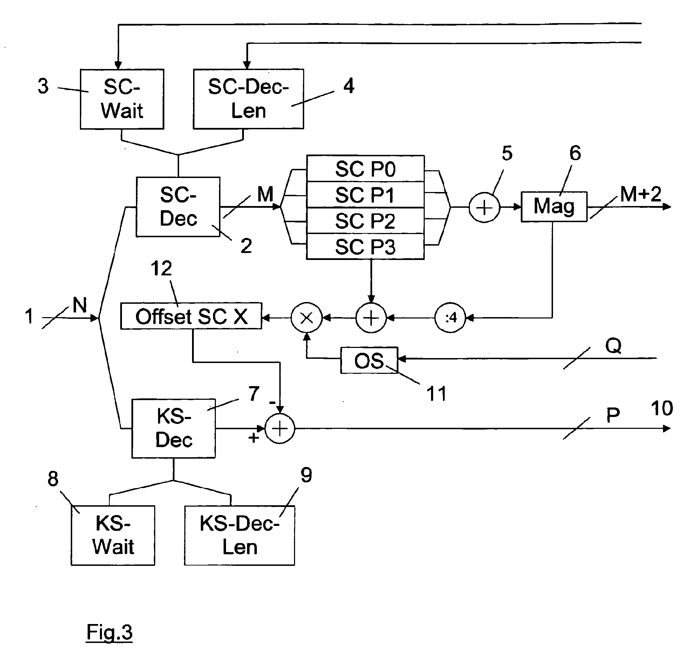

Da dieser Wert sich im Betrieb nicht ändert, kann er dem System ebenso wie KS-Dec-Len und SC-Dec-Len als Konstante übergeben werden. Fig. 3 zeigt hierzu die Offset-Korrektur des schnellen Messwertes mit dieser Skalierung der gemessenen Offset-Werte entsprechend dem Verhältnis der Dezimationslängen. Dies erfolgt hier durch die Vorgabe des Offset-Skalierungsfaktors 11 (OS), mit dem die aus dem SC-Messwert 6 und den Einzelphasen-Messwerten SCP0-SCP3 berechneten Offset-Werte multipliziert werden. Der entsprechend korrigierte Offset 12 wird dann entsprechend von den zweiten Abtastwerten subtrahiert.

Eine zweite zusätzliche Korrektur wird notwendig, wenn zusätzliche Magnetfelder ins System eingebracht werden. Dies kann z.B. der Fall sein, wenn mit einem konstanten Strom mit Hilfe einer integrierten Magnetfeld-Spule die Empfindlichkeit des Messsystems gemessen werden soll. Bei entsprechender Anwendung kann dies sogar gleichzeitig mit der Messung der Magnetfelder bzw. Ströme durchgeführt werden, ohne Messwerte zu verlieren.

In diesem Fall ist dem System jedoch der Magnetfeld-Hub durch die zusätzlich eingebrachten Magnetfelder bekannt und kann nachträglich von den schnellen Messwerten abgezogen werden. Damit die erzielbaren Genauigkeiten in beiden digitalen Messpfaden (schnelle und genaue Messung) optimal ausgenutzt werden können, müssen die Wartetakte (Wartezeiten) und Dezimationslängen (erster und zweiter Zeitraum) für beide Messungen so gewählt werden, dass gilt:

$$\text{SC-Wait + SC-Dec-Len = (KS-Wait + KS-Dec-Len) *Faktor,}$$

wobei Faktor = 2, 3, ... N.

Bei der Anwendung einer Offset-Zentrierung, wie sie aus der DE 10 2006 059 421 B4 bekannt ist, kann es erforderlich sein, dass der Stellwert für den in dieser Druckschrift verwendeten Offset-Korrektur-Wert, der immer für zwei SC-Phasen gemeinsam angewandt wird, im laufenden Betrieb korrigiert werden muss. Dadurch ändern sich auch bei gleich bleibendem Magnetfeld die jeweiligen Einzelphasen-Messwerte. Da jedoch die Größe der Änderung im System bekannt ist, kann diese Änderung auch im laufenden Betrieb in den schnellen Messwerten korrigiert werden.

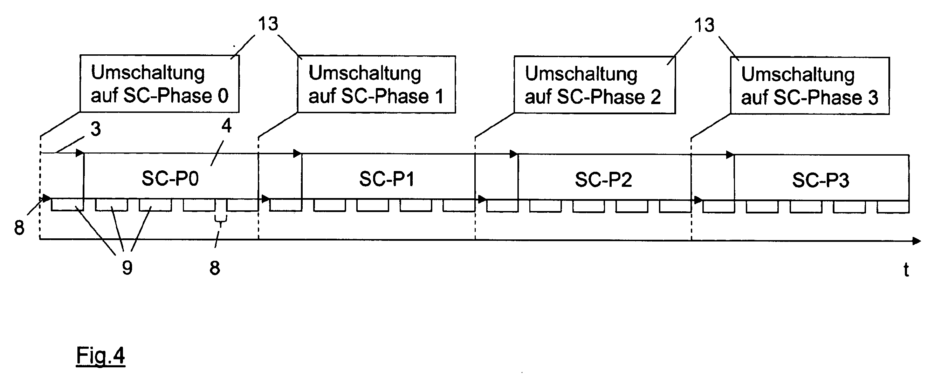

Bei dem vorgeschlagenen Verfahren sollten außerdem beide Mess-Zyklen so synchron laufen, dass die Wartezeit der schnellen Messung (zweite Wartezeit) gleichzeitig mit einer Wartezeit der langsamen Messung (erste Wartezeit) beginnt, da dann zwischen den Spinning-Current-Phasen umgeschaltet wird. Dies ist in der Figur 4 für einen Vier-Phasen-Betrieb schematisch angedeutet. In der Figur sind die Umschaltevorgänge 13, die erste und zweite Wartezeit 3, 8 sowie der erste und zweite Zeitraum 4, 9 für die schnelle und die genaue Messung angedeutet. Die Wartezeiten der schnellen Messung sind deutlich kürzer als die der genauen Messung. Dies ist jedoch zulässig, da auch nur eine geringere Genauigkeit von den schnellen Messwerten erwartet wird.

Bezugszeichenliste

1    Digitale Signalfolge des $\Delta\Sigma$-Modulators
2    Erster Dezimator (SC-Dec)
3    Erste Wartezeit (SC-Wait)
4    Erster Zeitraum (SC-Dec-Len)

5      Addierer
6      SC-Messwert
7      Zweiter Dezimator (KS-Dec)
8      Zweite Wartezeit (KS-Wait)
9      Zweiter Zeitraum (KS-Dec-Len)
10    Schneller Messwert
11    Offset-Skalierungsfaktor (OS)
12    Korrigierter Offset
13    Umschalten zwischen Phasen

## Patentansprüche

**1.** Verfahren zur Messung von Strömen oder Magnetfeldern mit mindestens einem Hallsensor, der in Spinning-Current-Technik betrieben wird, bei dem

- Sensorsignale des Hallsensors mit einem Analog-Digital-Wandler in digitale Signale (1) gewandelt werden,
- die digitalen Signale (1) des Analog-Digital-Wandlers ausgelesen und für jede Spinning-Current-Phase über einen ersten Zeitraum (4) kombiniert werden, um einen ersten Abtastwert zu erhalten, und
- die ersten Abtastwerte der Spinning-Current-Phasen eines Spinning-Current-Zyklus zur Bildung eines Spinning-Current-Messwertes (6) des Stroms oder Magnetfeldes aufaddiert werden,

**dadurch gekennzeichnet, dass**

- die digitalen Signale (1) des Analog-Digital-Wandlers für jede Spinning-Current-Phase mehrmals über jeweils einen zweiten Zeitraum (9) kombiniert werden, der kleiner als der erste Zeitraum(4) ist, um mehrere zweite Abtastwerte in zeitlicher Abfolge zu erhalten,
- aus dem Spinning-Current-Messwert (6) für jede Spinning-Current Phase ein Offset der ersten Abtastwerte berechnet und die zweiten Abtastwerte auf Basis dieses Offset korrigiert werden, um Offset-korrigierte schnelle Messwerte (10) des Stroms oder Magnetfeldes zu erhalten.

**2.** Verfahren nach Anspruch 1,
**dadurch gekennzeichnet,**
**dass** nach jedem Umschalten (13) der Spinning-Current-Phase eine erste Wartezeit (3) zwischen dem Umschalten (13) der Spinning-Current-Phase und dem Beginn des ersten Zeitraums (4) für die Bildung der ersten Abtastwerte eingelegt wird.

**3.** Verfahren nach Anspruch 2,
**dadurch gekennzeichnet,**
**dass** nach jedem Umschalten (13) der Spinning-Current-Phase eine zweite Wartezeit (8) zwischen dem Umschalten (13) der Spinning-Current-Phase und dem Beginn des zweiten Zeitraums (9) für die Bildung der zweiten Abtastwerte eingelegt wird, die gleich der ersten Wartezeit (3) oder kleiner als die erste Wartezeit (3) ist.

**4.** Verfahren nach einem der Ansprüche 1 bis 3,
**dadurch gekennzeichnet,**
**dass** die Sensorsignale des Hallsensors mit einem Delta-Sigma-Wandler erster Ordnung in digitale Signale (1) gewandelt werden.

**5.** Verfahren nach einem der Ansprüche 1 bis 4,
**dadurch gekennzeichnet,**
**dass** die Sensorsignale des Hallsensors vor der Analog-Digital-Wandlung verstärkt werden.

**6.** Verfahren nach einem der Ansprüche 1 bis 5,
**dadurch gekennzeichnet,**
**dass** die Kombination der digitalen Signale (1) über den ersten Zeitraum (4) durch einen ersten Dezimator (2) und die Kombination der digitalen Signale (1) über den zweiten Zeitraum (9) durch einen zweiten Dezimator (7) erfolgt.

**7.** Vorrichtung zur Messung von Strömen oder Magnetfeldern mit mindestens einem Hallsensor, der in Spinning-Current-Technik betrieben wird, wobei die Vorrichtung wenigstens umfasst:

- einen Analog-Digital-Wandler, mit dem Sensorsignale des Hallsensors in digitale Signale (1) gewandelt werden,
- einen ersten Kombinierer (2), der die digitalen Signale (1) des Analog-Digital-Wandlers ausliest und für jede Spinning-Current-Phase über einen ersten Zeitraum (4) kombiniert, um einen ersten Abtastwert zu erhalten, und
- einen Addierer (5), der die ersten Abtastwerte der Spinning-Current-Phasen eines Spinning-Current-Zyklus zur Bildung eines Spinning-Current-Messwertes (6) des Stroms oder Magnetfeldes aufaddiert,

**gekennzeichnet durch**

- einen zweiten Kombinierer (7), der die digitalen Signale (1) des Analog-Digital-Wandlers für jede Spinning-Current-Phase mehrmals über jeweils einen zweiten Zeitraum (9) kombiniert, der kleiner als der erste Zeitraum (4) ist, um mehrere zweite Abtastwerte in zeitlicher Abfolge zu erhalten, und
- eine Korrektur-Einheit, die aus dem Spinning-Current-Messwert (6) für jede Spinning-Current Phase einen Offset der ersten Abtastwerte berechnet und die zweiten Abtastwerte auf Basis dieses Offset korrigiert, um Offset-korrigierte schnelle Messwerte (9) des Stroms oder Magnetfeldes zu erhalten.

8. Vorrichtung nach Anspruch 7,
   **dadurch gekennzeichnet,**
   **dass** der Analog-Digital-Wandler ein Delta-Sigma-Wandler erster Ordnung ist.

9. Vorrichtung nach Anspruch 7 oder 8,
   **dadurch gekennzeichnet,**
   **dass** der erste Kombinierer (2) und der zweite Kombinierer (7) jeweils ein Dezimator ist.

## Claims

1. Method for measuring currents or magnetic fields with at least one Hall sensor which is operated in spinning current technology, in which

   - sensor signals from the Hall sensor are converted with an analogue-to-digital converter into digital signals (1),
   - the digital signals (1) of the analogue-to-digital converter are read out and combined for each spinning current phase over a first time period (4) to obtain a first sample, and
   - the first samples of the spinning current phases of a spinning current cycle are summed to form a spinning current measurement value (6) of the current or magnetic field,

   **characterized in that**

   - the digital signals (1) of the analogue-to-digital converter for each spinning current phase are combined a plurality of times over a respective second time period (9), which is smaller than the first time period (4), in order to obtain a plurality of second samples in chronological sequence,
   - for each spinning current phase an offset of the first samples is calculated from the spinning current measurement value (6), and the second samples are corrected on the basis of this offset, in order to obtain offset-corrected fast measurement values (10) of the current or magnetic field.

2. Method according to claim 1,
   **characterized in that**
   after each switching (13) of the spinning current phase a first wait time (3) is inserted between the switching (13) of the spinning current phase and the beginning of the first time period (4) for forming the first samples.

3. Method according to claim 2,
   **characterized in that**
   after each switching (13) of the spinning current phase a second wait time (8) is inserted between the switching (13) of the spinning current phase and the beginning of the second time period (9) for forming the second samples, which is equal to the first wait time (3) or shorter than the first wait time (3).

4. Method according to any one of claims 1 to 3,

**characterized in that**
the sensor signals from the Hall sensor are converted into digital signals (1) with a first order delta-sigma converter.

5. Method according to any one of claims 1 to 4,
   **characterized in that**
   the sensor signals from the Hall sensor are amplified prior to the analogue-to-digital conversion.

6. Method according to any one of claims 1 to 5,
   **characterized in that**
   the digital signals (1) are combined over the first time period (4) by means of a first decimator (2) and the digital signals (1) are combined over the second time period (9) by a second decimator (7).

7. Apparatus for measuring currents or magnetic fields with at least one Hall sensor that is operated in spinning current technology, wherein the apparatus at least comprises:

   - an analogue-to-digital converter, with which sensor signals from the Hall sensor are converted into digital signals (1),
   - a first combiner (2), which reads out the digital signals (1) from the analogue-to-digital converter and combines them for each spinning current phase over a first time period (4) in order to obtain a first sample, and
   - an adder (5), which sums the first samples of the spinning current phases of a spinning current cycle to form a spinning current measurement value (6) of the current or magnetic field,

   **characterized by**

   - a second combiner (7), which combines the digital signals (1) from the analogue-to-digital converter for each spinning current phase a plurality of times over a respective second time period (9), which is smaller than the first time period (4), in order to obtain a plurality of second samples in chronological sequence, and
   - a correction unit, which calculates from the spinning current measurement value (6), for each spinning current phase, an offset of the first samples and corrects the second samples on the basis of this offset, in order to obtain offset-corrected fast measurement values (10) of the current or magnetic field.

8. The apparatus according to claim 7,
   **characterized in that**
   the analogue-to-digital converter is a delta-sigma converter of the first order.

9. The apparatus according to claim 7 or 8,
   **characterized in that**
   each of the first combiner (2) and the second combiner (7) is a decimator.

**Revendications**

1. Procédé de mesure de courants ou de champs magnétiques avec au moins un capteur à effet Hall, qui fonctionne selon la technique de courant tournant (spinning current), dans lequel

   - des signaux de capteur du capteur à effet Hall sont convertis avec un convertisseur analogique à numérique en signaux numériques (1),
   - les signaux numériques (1) du convertisseur analogique à numérique sont lus et pour chaque phase de courant tournant sont combinés sur une première période (4) pour obtenir un premier échantillon et
   - les premiers échantillons des phases de courant tournant d'un cycle de courant tournant (6) sont additionnés pour former une valeur de mesure de courant tournant du courant ou du champ magnétique,

   **caractérisé en ce que**

   - les signaux numériques (1) du convertisseur analogique à numérique pour chaque phase de courant tournant sont combinés plusieurs fois sur respectivement une deuxième période (9), qui est plus petite que la première période (4), pour obtenir plusieurs deuxièmes échantillons en séquence temporelle,
   - d'après la valeur de mesure de courant tournant (6) pour chaque phase de courant tournant, un décalage (10) des premiers échantillons est calculé et les deuxièmes d'échantillons sont corrigés sur la base de ce décalage pour obtenir une valeur de mesure rapide corrigée par décalage du courant ou du champ magnétique.

2. Procédé selon la revendication 1,
**caractérisé en ce que**
après chaque commutation (13) de la phase de courant tournant un premier temps d'attente (3) entre la commutation (13) de la phase de courant tournant et le début de la première période (4) est appliquée pour la formation des premiers échantillons.

3. Procédé selon la revendication 2,
**caractérisé en ce que**
après chaque commutation (13) de la phase de courant tournant un deuxième temps d'attente (8) entre la commutation (13) de la phase de courant tournant et le début de la deuxième période (9) est appliquée pour la formation des deuxièmes échantillons, qui est égal au premier temps d'attente (3) ou inférieur au premier temps d'attente (3).

4. Procédé selon une des revendications 1 à 3,
**caractérisé en ce que**
les signaux de capteur du capteur à effet Hall sont convertis avec un convertisseur delta-sigma du premier ordre en signaux numériques (1).

5. Procédé selon une des revendications 1 à 4
**caractérisé en ce que**
les signaux de capteur du capteur à effet Hall sont amplifiés avant la conversion analogique à numérique.

6. Procédé selon une des revendications 1 à 5,
**caractérisé en ce que**
la combinaison des signaux numériques (1) sur la première période (4) est effectuée par un premier décimateur (2) et la combinaison des signaux numériques (1) sur la deuxième période (9) est effectué par un deuxième décimateur (7).

7. Dispositif de mesure de courants ou de champs magnétiques comportant au moins un capteur à effet Hall, qui fonctionne selon la technique de courant tournant (spinning current), dans lequel le dispositif comprend au moins :

- un convertisseur analogique à numérique, avec lequel des signaux de capteur du capteur à effet Hall sont convertis en signaux numériques (1),
- un premier combinateur (2), qui lit les signaux numériques (1) du convertisseur analogique à numérique et combine pour chaque phase de courant tournant sur une première période (4), afin d'obtenir un premier échantillon et
- un sommateur (5), qui additionne les premiers échantillons des phases de courant tournant d'un cycle de courant tournant pour former une valeur de mesure de courant tournant (6) du courant ou du champ magnétique,

**caractérisé en ce que**

- un deuxième combinateur (7), qui combine les signaux numériques (1) du convertisseur analogique à numérique pour chaque phase de courant tournant plusieurs fois sur respectivement une deuxième période (9), qui est plus petite que la première période (4), afin d'obtenir plusieurs deuxièmes échantillons en séquence temporelle et
- une unité de correction, qui d'après la valeur de mesure de courant tournant (6) pour chaque phase de courant tournant calcule un décalage des premiers échantillons et corrige les deuxièmes échantillons sur la base de ce décalage, afin d'obtenir des valeurs de mesure (9) rapides corrigées par décalage du courant ou du champ magnétique.

8. Dispositif selon la revendication 7,
**caractérisé en ce que**
le convertisseur analogique à numérique est un convertisseur delta sigma du premier ordre.

9. Dispositif selon la revendication 7 ou 8,
**caractérisé en ce que**

le premier combinateur (2) et le deuxième combinateur (7) est respectivement un décimateur.

Fig.1

Fig.2

Fig.3

Umschaltung auf SC-Phase 3

Umschaltung auf SC-Phase 2

Umschaltung auf SC-Phase 1

Umschaltung auf SC-Phase 0

13

13

SC-P3

SC-P2

SC-P1

SC-P0

4

3

8

9

8

t

Fig.4

14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2009009164 A1

- DE 102006059421 B4

**In der Beschreibung aufgeführte Nicht-Patentliteratur**

- **A. KERLAIN et al.** Hybrid Hall microsystem for high dynamic range/large bandwidth magnetometry applications. *IEEE SENSORS 2008 Conference,* 1044-1047